**Europäisches Patentamt**

**European Patent Office**

**Office européen des brevets**

(11) Publication number: **0 118 007**
**B1**

(12) # EUROPEAN PATENT SPECIFICATION

(45) Date of publication of patent specification: **23.05.90**

(21) Application number: **84100823.8**

(22) Date of filing: **26.01.84**

(51) Int. Cl.⁵: **H 01 L 29/74, H 01 L 29/743, H 05 B 39/00**

(54) **Electrical circuit comprising a hybrid power switching semiconductor device including an SCR structure.**

(30) Priority: **04.02.83 US 464161**

(43) Date of publication of application:
**12.09.84 Bulletin 84/37**

(45) Publication of the grant of the patent:
**23.05.90 Bulletin 90/21**

(84) Designated Contracting States:
**DE FR GB**

(56) References cited:
**EP-A-0 014 435**
**EP-A-0 043 009**
**FR-A-2 488 046**
**GB-A-2 088 631**

**IEDM TECHNICAL DIGEST, 13th-15th December 1982, San Francisco, CA, US, pages 264-267, IEEE, New York, US; B.J. BALIGA et al.: "The insulated gate rectifier (IGR): A new power switching device"**

(73) Proprietor: **GENERAL ELECTRIC COMPANY**
**1 River Road**
**Schenectady New York 12305 (US)**

(72) Inventor: **Baliga, Bantval Jayant**
**3 Clove Court**
**Clifton Park New York 12065 (US)**

(74) Representative: **Schüler, Horst, Dr. et al**
**Kaiserstrasse 69**
**D-6000 Frankfurt/Main 1 (DE)**

Courier Press, Leamington Spa, England.

## Description

### Background of the invention

The present invention relates to an electrical circuit comprising an electrical lamp filament of the type which dranes a relatively higher inrush current when initially energized and a relatively lower operating current thereafter, and an insulated-gate rectifier for controlling energization of said lamp filament, said insulated-gate rectifier including a parasitic PNPN thyristor structure.

Various types of three-terminal power switching semiconductor devices are known, the various device types in many cases having different operating characteristics and being suitable for various and different specific circuit applications.

One general type of power switching semiconductor device is a thyristor, a common example of which is a silicon-controlled rectifier (SCR). An SCR is a four-layer PNPN switching device having the advantageous characteristic of relatively high current-carrying capability. Another advantageous characteristic of an SCR is the ability to block reverse voltages. However, as is well known, a disadvantage of a conventional SCR is that the gate electrode controls only turn-on of the device. Once triggered into conduction through application of suitable gate voltage, an SCR latches on through a regenerative switching action and remains conducting, even though gate voltage is thereafter removed. An SCR does not turn off until forward current through the device drops below a certain holding current value characteristic of any given SCR, at which point the regenerative switching action is no longer maintained.

A typical SCB or thyristor comprises, in succession, a P$^+$ (or highly doped P-type) emitter region which serves as the device anode region, an N$^-$ (or lightly doped N-type) base region, a P (or P-type, of a reference doping level) base region, and an N$^+$ emitter region which serves as the device cathode region.

Particularly relevant in the context of the present invention is a specialized form of thyristor or SCR known as a MOS-gated SCR or thyristor or, more generally, an insulated-gate triggered SCR or thyristor. Such devices are disclosed, for example, in Yamashita et al US—A—3,753,055 and Savidge US—A—3,831,187. A MOS-gated SCR is a PNPN thyristor structure in which regenerative turn-on is initiated by application of a voltage to an insulated gate. These devices combine the current-carrying capability of an ordinary SCR, with the additional advantage of requiring relatively low gate power to turn on the device via the MOS gate. However, MOS-gated SCRs do not exhibit gate turn-off capability.

One of the reasons an SCR has a relatively high current capability is that during forward conduction all three PN junctions within the device are forward-biased and a bipolar conduction mode occurs. In particular, the two device intermediate regions, (one of P conductivity type and one of N conductivity type) each constitute what, for convenience, is herein termed an "active-base" region, signifying that conduction in such a region involves more than the mere flow of majority carriers, i.e., electrons in the case of an N conductivity type region and holes in the case of a P conductivity type region. Rather, both electrons and holes are injected into such "active-base" regions, as employed herein, during device operation, and a rapid rate of recombination occurs in these device active-base regions, increasing device conductivity.

Deserving mention in the context of the present invention is a two-transistor analogue which as is well known, can for many analysis purposes be employed to represent a four-layer PNPN thyristor structure. The two-transistor analog comprises an upper NPN bipolar transistor and a lower PNP bipolar transistor, with the base of the NPN transistor connected to (and comprising the same device region as) the collector of the PNP transistor, and the base of the PNP transistor corresponding to (and comprising the same device region as) the collector of the NPN transistor. Each of these two bipolar transistors is characterized in part by a common-base current gain. The overall device is regenerative, i.e. can latch into a conducting state, when the device structure and current flow are such that the sum of the common-base current gains of the two transistors is in excess of unity.

Also deserving mention is the common inclusion in SCR structures of cathode shorts for the purpose of improving dV/dt capability, i.e. reducing the tendency of the device to switch to its ON state due to a rapidly-increasing anode voltage, even though the magnitude of the anode voltage remains well below device breakover voltage. Specifically, a "cathode short" comprises a short between the device N$^+$ cathode region and the adjacent P base region. A given device has a cathode shorting density determined by the relative contact areas of the cathode electrode with the adjacent base region and with the N$^+$ cathode region itself. In SCRs, a relatively low cathode shorting density is employed, sufficient to enhance the dV/dt capability, but not so high that regenerative switching action is prevented.

Another known general type of three-terminal power switching semiconductor device is a power MOSFET, examples of which are disclosed in Ishitani US—A—4,072,975, and in Blanchard US—A—4,145,705. Such a device may more generically be termed an insulated-gate field-effect transistor (IGFET), and the two terms, MOSFET and IGFET, are employed interchangeably herein.

A typical N-channel power MOSFET includes an N$^+$ (or highly-doped N conductivity type) source region and an N (or high resistivity N conductivity type) drift or drain region separated from each other by a P shield-base region having a channel surface. An insulated gate electrode is disposed over the channel surface. In operation, application of a sufficiently large positive gate electrode bias (with reference to the source region) through a depletion process results in the formation of an N conductivity type inversion layer in the P shield-base region just below the channel surface. The inversion layer thus comprises an induced conduction channel allowing the conduction of electrical current from the source to the drain. Significantly, the gate maintains both turn-on and turn-off control.

MOSFETs are unipolar conduction devices. In particular, in MOSFET devices, it is primarily majority carrier (e.g. electron) current which flows between source and drain. The N drain region is merely a drift region, and does not function as an active base region wherein recombination occurs. Because excess charge carriers (electrons and holes) do not accumulate in the N conductivity type drift region, device turn off is extremely rapid, and a power MOSFET is capable of relatively high switching speeds, e.g. in excess of 100 MHz. Related to the unipolar conduction mode is the fact that there is no regenerative turn-on mechanism intended in MOSFET structures, and this is one reason the gate at all times maintains control over MOSFET conduction, in contrast to an SCR.

One disadvantage of a power MOSFET is relatively high on-resistance. The reason is that current flow is limited by the majority carrier (electron) concentration in the N conductivity type induced channel and N conductivity type drift regions, which determines their resistivity. For devices designed for operation at greater than 100 volts, the resistance of the drift region becomes large because, in order to support the device blocking voltages, the majority carrier concentration in the drift region must be small and the drift region width must be large in order to support the device blocking voltages. In consequence, due to the high drift region resistance, high voltage MOSFET devices must be operated at low current densities to obtain low forward voltage drops.

Power MOSFETs also include shorts. Specifically, these are source-to-base shorts, corresponding to cathode shorts in an SCR, but with a higher shorting density such that operation of a parasitic NPN bipolar transistor inherent in the MOSFET device structure is inhibited. Operation of this parasitic bipolar transistor would otherwise degrade the switching speed of the MOSFET device.

A third type of three-terminal power switching semiconductor device is known as an insulated-gate rectifier (IGR), various forms of which are disclosed in commonly-assigned DE—A—31 47 075, filed November 27, 1981 by B. J. Baliga and entitled "Gate Enhanced Rectifier". (It may be noted that a "gate enhanced rectifier", or "Gerect", is alternatively referred to herein as an "insulated-gate rectifier", or "IGR". The two terms "GERECT" and "IGR" are intended to mean the same device).

Briefly, an IGR is a semiconductor device having an insulated gate for controlling flow between its main electrodes, i.e., between its anode and cathode terminals. The gate and conduction channel of an IGR are similar to corresponding elements to a MOSFET with, however, important differences between the two devices (an IGR and a MOSFET), as described in detail in the above-identified DE—A—31 47 075 and summarized below.

Previously-disclosed IGRs may appear to be structurally similar to vertical channel MOSFETs, with an important distinction. In particular, assuming the case of an N-channel device, a $P^+$ anode region, not found in a MOSFET, is included. A four-layer, i.e. PNPN, device therefore results. Operation also differs from that of a MOSFET, the most significant consquence of the operational difference being that the IGR has much higher forward conductivity.

In particular, as summarized above, a power MOSFET is a unipolar conduction device wherein conduction occurs primarily by simple electron current flow, without the presence of excess carriers. In contrast, in an IGR, the $P^+$ anode region injects minority carriers (e.g. holes) into the N conductivity type region corresponding to the drift region of a MOSFET. As in an SCR as summarized above, the drift region of an IGR constitutes what, for convenience, is herein termed an "active-base" region, signifying that conduction in this particular region involves more than the mere flow of majority carriers, e.g. electrons. Rather, during operation the holes introduced into the active-base region recombine with electrons introduced from the cathode, increasing device conductivity. The conduction mode is therefore bipolar in part. The P base region in an IGR serves primarily to support the induced conduction channel, as in a MOSFET, and thus maintains the same character as an inactive shield-base region, not supporting a bipolar conduction process.

An IGR differs from a four-layer PNPN thyristor, even though some forms of IGR are superfically somewhat similar structurally to typical MOS-gated SCR or thyristor structures, and even though an IGR may be considered as including a parasitic SCR. Significantly, in the normal operation of an IGR, the gate electrode maintains both turn-on and turn-off control of current flow through the device, and the parasitic SCR is not permitted to latch into a conducting state (of, e.g., IEDM82, p. 264—267, IEEE, New York 1982).

There are various methods by which the parasitic SCR inherent in an IGR structure can be inhibited from operating, which would undesirably latch the IGR into a conducting state with consequent loss of gate control.

A primary approach, and one which is described in the above-identified DE—A—31 47 075, is to employ in the IGR a relatively high cathode shorting density relative to the cathode shorting density which would be employed in an SCR structure. In an IGR, this cathode shorting density is sufficiently high such that the current gain of the upper NPN transistor of the two-transistor analogue mentioned above is maintained at a low-enough value such that regenerative turn-on action of the device is prevented. Alternatively, the cathode shorting density may be viewed as having the effect of preventing the PN junction between the P base region and the $N^+$ cathode region from becoming forward biased to the point where a strong injection of carriers occurs from the $N^+$ conductivity type cathode into the P base region.

Nevertheless, in an IGR, there is a tendency for the parasitic SCR to latch on (resulting in loss of gate control) as current through the device is increased. This phenomenon is analyzed in detail in commonly-assigned EP—A—0091686 by B. J. Baliga, P. V. Gray, and R. P. Love and entitled "Semiconductor Device Having a Diffused Region of Reduced Length and Method of Fabricating the Same", and in commonly-assigned EP—A—0091094 by M. S. Adler and B. J. Baliga, and entitled "Insulated Gate Rectifier With Improved Current-Carrying Capability". Various structures, which are alternatives to cathode shorts, are disclosed in these applications EP—A—0091696 and EP—A—0091094.

In pertinent summary, structurally, there can be a fine line between a MOS-gated SCR and an IGR, depending upon the effectiveness of the measures taken to inhibit turn-on of the parasitic SCR. The factors leading to turn-on of the SCR increase as current flow through the device occurs which, in the normal operation of an IGR, results in the device having a maximum current rating which must not be exceeded if latch-on of the device is to be avoided. Also, as will be appreciated by those skilled in the art, conventional SCRs are characterized by a holding current rating, which is a minimum current which must be maintained through the device in order to sustain the regenerative switching mechanism.

Up to this point, the background description herein has been concerned with specific types of semiconductor power switching devices. However, also relevant in the context of the present invention are the characteristics of specific circuits in which these devices are usefully employed.

More particularly, there is one type of circuit including a general class of load devices characterized by drawing a relatively higher inrush current when initially energized, and a relatively lower operating current thereafter. A typical example of such a load device is a filament, such as an incandescent lamp filament, a discharge lamp filament, or even a vacuum tube filament. As a typical numerical example applying to a specific discharge lamp filament, upon initial turn-on, a filament current in the order of 10 amperes must be handled by the power switch. As the filament heats up, its electrical resistance increases by 20 times, and the current drops to a level of 0.5 amperes.

In one specific lamp control circuit, in order to control filament power at this point the power device must operate in the gate turn-off mode at switching frequencies up to 80 kHz.

It has previously been suggested for this application to employ two separate devices, a MOSFET and an SCR connected in parallel. In this suggested approach, the SCR is used initially to carry the 10 amperes of filament current. When the filament heats up, the current drops to less than one ampere. At this point, the MOSFET is turned on. If the SCR is designed with a holding current rating of one ampere, the SCR will now turn off and the MOSFET can be then used to achieve the high frequency switching.

In accordance with the present invention, there are provided approaches which combine both an SCR and a high frequency power switching device into a single semiconductor chip.

Summary of the invention

Accordingly, it is an object of the invention to provide an electrical circuit including a single semiconductor device advantageously combining the current-carrying capabilities of an SCR with the high speed switching capabilities of another type of semiconductor device.

It is a related object of the invention to employ a single device in the place of two devices previously employed, thereby reducing the overall cost of semiconductor chips and packages, as well as simplifying gate drive circuitry.

Briefly, and in accordance with an aspect of the invention, as claimed an electrical circuit comprises an electrical lamp filament, of the type which draws a relatively higher inrush current when initially energized, and a relatively lower operating current thereafter. Electrically connected to the electrical lamp filament for controlling energization thereof is an insulated-gate rectifier of the type including a parasitic PNPN thyristor structure. The parasitic thyristor structure has a holding current rating, and the insulated-gate rectifier is configured and arranged such that the holding current rating is less than the inrush current of the lamp filament and greater than the gate-controlled operating current of the lamp filament. More particularly, the insulated gate rectifier has a pair of main terminals and a control gate terminal, and the main terminals are electrically connected to the electrical lamp filament for controlling energization thereof. When the relatively higher inrush current flow through the insulated-gate rectifier, the parasitic PNPN thyristor is latched into a conducting state uncontrollable by means of the control gate terminal. When the relatively lower operating current flows, the parasitic PNPN thyristor is not latched into a conducting state, whereby conduction through the insulated gate rectifier is controllable by means of the control gate terminal.

A method for operating an insulated-gate rectifier of the type including a parasitic PNPN thyristor structure having a holding current rating includes the steps of selectively operating the insulated-gate rectifier as an insulated-gate-triggered thyristor at operating currents equal to or in excess of the holding current, and as a gate-controlled insulated-gate rectifier at operating current levels less than the holding current. More particularly, the insulated-gate recitifier controls energization of the electrical lamp filament, which draws a relatively higher inrush current when initially energized and a relatively lower operating current thereafter, and wherein the inrush current is at least as great as the holding current rating of the parasitic PNPN thyristor structure, and the gate-controlled operating current is less than the holding current rating of the parasitic PNPN thyristor structure.

For operating frequencies in excess of 100 kHz, the approximate upper limit for an IGR, a faster hybrid device is required. Accordingly, further forms of hybrid device can be used which combine, in a single integrated device, an SCR structure and a MOSFET structure.

Brief description of the drawings

While the novel features of the invention are set forth with particularity in the appended claims, the invention, both as to organization and content, will be better understood and appreciated from the following detailed description taken in conjunction with the drawings, in which:

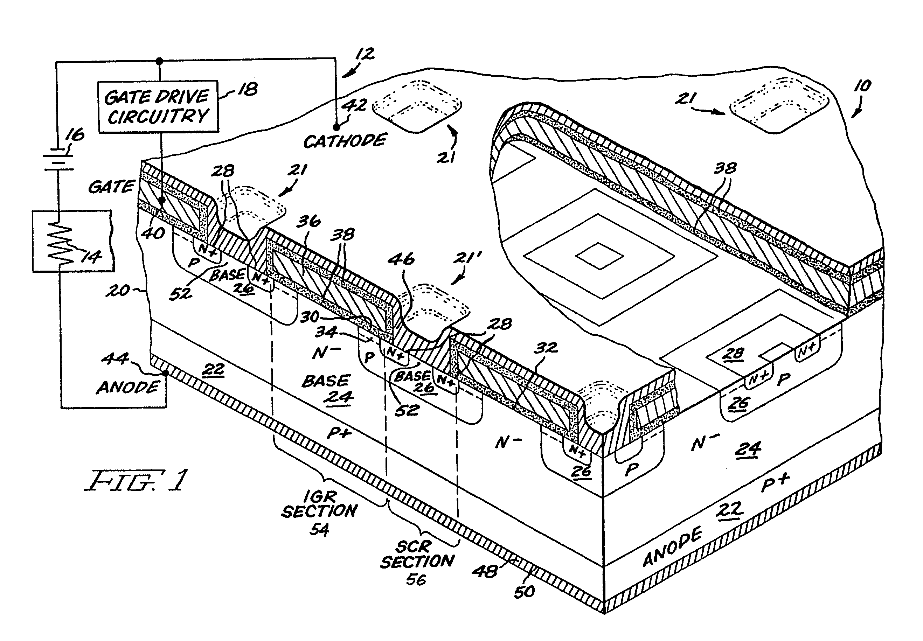

Fig. 1 is a highly-schematic sectioned isometric view of an IGR/SCR hybrid power switching semiconductor device in accordance with the invention, connected in a circuit also embodying the invention.

Detailed description of the preferred embodiments

Referring to Fig. 1, depicted in highly-schematic form is an IGR/SCR hybrid power switching semiconductor device, generally designated 10, included within an electrical circuit 12 comprising, in addition to the device 10, an electrical load device 14, a DC power source represented at 16, and suitable gate drive circuitry 18 for the semiconductor device 10.

The hybrid device 10 is fabricated, for purposes of example, as a vertical-channel device employing double-diffused metal-oxide-semiconductor (DMOS) technology. It will be appreciated, however, that other forms of device may be fabricated, for example, employing "V"-groove MOS (VMOS) technology. Further descriptions of DMOS and VMOS structures are found in S. M. Sze, *Physics of Semiconductor Devices*, second edition, John Wiley & Sons, Inc., publisher, 1981, pages 489, 490, 494 and 495.

In structural overview, the hybrid device 10 of Fig. 1 resembles an insulated-gate rectifier such as is disclosed in the above-cited Baliga application DE—A—31 47 075. However, there is a significant difference in the result of the measures taken to inhibit operation of the parasitic SCR included within the device structure, although the structural differences are somewhat subtle. It will be appreciated, since Fig. 1 is a highly schematic representation, not to scale, that the geometrical differences are not necessarily readily apparent from the drawing. However, the required structure will be well apparent to those skilled in the art in view of the functional requirements stated herein.

In detail, the hybrid device 10 of Fig. 1 includes a body 20 of semiconductor material, such as silicon, including in series, a $P^+$ anode region 22 (highly-doped to P conductivity type), a first or $N^-$ base region 24 (lightly-doped to N conductivity type), a second or P base region 26 (doped to a reference concentration with P conductivity type impurities), and an $N^+$ cathode region 28 (highly-doped to N conductivity type).

As shown, preferably the device 10 includes a plurality of individual unit cells 21, all of which share common anode 22 and first base ($N^-$ base) regions 24, but which have individual second base (P base) 26 and $N^+$ cathode 28 regions. For convenience, and clarity, the structure of only one of the identical unit cells 21, cell 21', is described herein.

The body 20 has at least one channel surface 30 which in the illustrated embodiment, is coextensive with the upper principal surface 32 of the body 22. This channel surface 30 may be provided by means of conventional DMOS fabrication technology. At least a portion of the second base (P base) region 26 is adjacent to the channel surface 30, and the cathode region 28 and the first base ($N^-$ base) region 24 are spaced from each other to define a channel portion 34 within and extending into the second base region 26 from the channel surface 30.

Positioned over the channel surface 30 is an insulated gate electrode 36 configured for inducing in the channel portion 34, when gate voltage is applied, an N conductivity type conduction channel extending between the $N^+$ cathode region 28 and the first base ($N^-$ base) region 24. The gate electrode 36 is insulated from the semiconductor body 20 by being encased within an insulating oxide layer 38, for example of silicon dioxide. The gate electrode 36 may, for example, comprise aluminium or highly-doped polycrystalline silicon of either conductivity type, as is known in the art. The gate electrode 36 is electrically connected to a device gate terminal, represented at 40, by any one of various techniques known to those skilled in the art. One representative example is a remote gate contact terminal formed by etching through the oxide layer 38 to the upper surface of the conductive gate electrode layer 36 to apply a metal contact. The gate electrode 36 and encasing oxide 38 cover substantially the entire device surface 32, except where windows are provided for cathode metallization, described next below.

The device 10 has two main terminals, a device cathode terminal 42 and a device anode terminal 44, both shown in schematic form. The device cathode terminal 42 is connected to a device terminal electrode 46 comprising metallization, for example aluminum, applied to essentially the entire upper surface of the device (except where there are remote gate contact terminals) and contacting the cathode region 28, forming an ohmic contact therewith. The cathode metallization 46 is prevented from contacting the first base region 24 of N⁻ conductivity type and from contacting the gate electrode 36 by virtue of the encasing oxide 38.

The device anode terminal 44 is electrically connected to an anode terminal electrode 48 in ohmic contact with the device anode region 22 on the lower device principal surface 50.

It will be appreciated that the illustrated electrode arrangement, as well as the surface 32 geometry, is exemplary only, and that numerous alternative arrangements may be employed. As one example, a more complicated metallization pattern may be employed, with the gate electrode directly metallized, and separate patterned metallization areas for the cathode electrode 46.

In order to provide cathode shorts, a shorting extension 52 of the P conductivity type second base region 26 extends upward to the principal surface 32, in contact with the cathode metallization 46. An important aspect of the invention is the control of cathode shorting density, which is determined in part by the contact area of the cathode electrode metallization 46 with the second base region 26 relative to the overall cathode terminal electrode contact area including the contact area with the N⁺ cathode region 28.

It will be appreciated that the Fig. 1 device structure 10 can have the characteristics of either an IGR or an SCR, depending upon the level of forward current flow through the device 10 and depending upon the measures taken to inhibit operation of the included parasitic SCR structure. Various such measures are discussed in the above-cited commonly-assigned DE and EP applications, the entire disclosures of which are hereby incorporated by reference herein.

In brief summary, and as mentioned above, it is well known that a four-layer PNPN thyristor structure may be represented by a two-transistor analogue comprising an upper NPN transistor and a lower PNP transistor, with the base of the NPN transistor connected to (and comprising the same region as) the collector of the PNP transistor, and the base of the PNP transistor corresponding to (and comprising the same device region as) the collector of the NPN transistor.

Each of these two transistors is characterized by having a common-base current gain and the overall device becomes regenerative, i.e. latches into a conducting state, when the sum of the two current gains exceeds unity. If the sum of these two common base current gains is less than unity, then the device is not regenerative.

Accordingly, in previous SCR device structure, the sum of the two common-base current gains exceeds unity, and the SCRs are therefore regenerative. In previously-disclosed IGR structures such regeneration is undesired, and the characteristics of the two transistors of the analogue are controlled such that the sume of their common-base current gains is less than unity.

Moreover, as is well known, the common-base current gains of both the upper NPN and the PNP transistors in the two-transistor analogue increase with increasing device current, and decrease with decreasing device current. It is for this reason that conventional SCRs have a certain holding current rating below which the device is no longer regenerative and the device turns off. Further, this is the general reason that previously-proposed IGR structures have a maximum current rating, above which the parasitic SCR undesirably latches into conduction. Various techniques for controlling and minimizing this effect have previously been disclosed, as summarized in the various United States patent applications cited above.

In accordance with the present invention, it is recognized that a useful device structure may be provided by controlling the configuration of the various regions of the device 10, through any suitable technique or combination of techniques, such that the device 10 behaves as an IGR for operating currents extending from zero current up to a mode crossover current point, and behaves as an SCR for operating currents extending from the mode crossover current point up to a device maximum current range. A typical mode crossover point is one ampere.

Significantly, the mode crossover current point is within the device intended operating current range, rather than being at one end or the other. In an SCR, the current below which the device is no longer regenerative, i.e., the holding current, determines the lower end of the device operating current range. In an IGR, the current above which the device undesirably latches into a conducting mode whereby gate control is lost determines the upper end of the device operating current range.

To represent the dual nature of the hybrid device 10, an IGR section 54 and an SCR section 56 are shown in Fig. 1. In the IGR section 54, conduction occurs through the channel portion 34. In the SCR section 58, conduction occurs through the P conductivity type base region 26.

More particularly, during the IGR mode of operation, the device 10 supports forward conduction when a positive gate voltage is applied on the gate electrode 36 to induce, through inversion, an N type conduction channel in the channel portion 34 between the N⁺ cathode region 28 and the N⁻ first base region 24. During this mode of operation, electrons from the cathode region 28 are injected via the induced conduction channel 34 into the N⁻ conductivity type first base region 24. At the same time, holes are injected from the P⁺ anode region 22 into the N⁻ first base region 24. These electrons and holes recombine in the N⁻ first base region 24 in a bipolar conduction mode. Thus, while the N⁻ first base region 24 fucntions as an active-base region, the second base region 26 does not, and serves only as a shield-base region. Thus, the IGR section represented at 54 actively functions.

To turn off the device 10 in its IGR mode, positive gate voltage is removed from the gate electrode 36, and the conduction channel 34 is no longer induced. At this point, the device 10 no longer sustains conduction.

At higher currents, that is, above the mode crossover current point, the SCR section represented at 56 actively functions as a MOS-gated SCR, which latches into a conduction mode in which gate control is lost.

While the SCR mode of operation may be explained in various ways, one way in which the operation of the device 10 in its SCR mode of operation may be explained is as follows. When a positive gate voltage is applied via the gate electrode 36, an electric field across the gate insulating layer 38 produces a depletion of carriers in the P conductivity type second base region 26 under the gate electrode 36. As a result, the depletion layer in the P conductivity type base region 26 extends closer to the $N^+$ conductivity type cathode region 38 under the gate 36. This reduces the thickness under the gate electrode 36 of the undepleted P conductivity type base region 26 of the upper NPN transistor of the two-transistor analogue, and thus increases its current gain. In the MOS-gated thyristor, as the gate bias is increased, the common-base current gain of the upper NPN transistor increases until the sum of the common-base current gains of the upper NPN and the lower PNP transistors exceeds unity. At this point, strong injection of carriers occurs from the $N^+$ cathode region 28 into the P conductivity type base region 26, and the device switches to the ON state. Once this takes place, removal of gate bias voltage will not cause the device 10 to return to the blocking state because of the self-sustaining regenerative action inherent in the PNPN thyristor structure.

It will be appreciated that, during this SCR mode of operation, both the $N^-$ conductivity type first base region 24 and the P conductivity type second base region 26 function as active base regions, supporting bipolar conduction.

There are various methods by which the different regions of the device 10 may be configured such that operation occurs as described above. Preferably, this result is achieved through control of the cathode shorting density. In previous IGR structures, the $N^+$ cathode regions 28 are relatively small, and a consequently relatively large area of the shorting extension 52 of the P conductivity type second base region 26 is therefore in contact with the cathode metallization 46 for a relatively high cathode shorting density. In previous SCR structures, a relatively low cathode shorting density is employed (with relatively larger cathode regions 28) only to the extent necessary to achieve the desired dV/dt characteristic. In accordance with the present invention, an intermediate value of cathode shorting density is employed, as will be well appreciated by those skilled in the art.

Although the Fig. 1 device 10 is depicted as a basic vertical-channel device fabricated employing DMOS technology, it will be appreciated that a variety of other device configurations may be employed, and the configuration of Fig. 1 is for representative purposes only. As another variation, to increase turn-off speed, it will be appreciated that anode shorts may also be employed, which are omitted from Fig. 1 for clarity of illustration. "Anode shorts" are shorts between the device $P^+$ anode region 22 and the adjacent $N^-$ base region 24, and can be implemented by downward shorting extensions (not shown) of the $N^-$ base 24, in contact with the anode metallization 48. Anode shorts aid in improving turn-off speed of an IGR (as well as of an SCR) due to the bipolar conduction mode. In particular, during conduction in an IGR or SCR, there are excess electrons and holes in the $N^-$ conductivity tyupe first base region 24, which functions as an active-base region. Upon device turn-off, these electrons and holes are momentarily trapped in the $N^-$ base region 24, prolonging device conduction and therefore degrading turn-off speed. Excess holes in the $N^-$ base region 24 exit towards the cathode electrode 46 through the P conductivity type base region 26. However, in the absence of an anode short, there is no similar path for excess electrons in the $N^-$ base region 24. The inclusion of anode shorts overcomes this particular difficulty. Suitable anode short structures are described in the above-identified Baliga Application DE—A—31,47,075.

A structural alternative to conventional anode shorts is disclosed in commonly-assigned EP—A—0080044 by B. J. Baliga and entitled "Semicondcutor Device Having Rapid Removal of Majority Carriers From an Active Base Region Thereof at Device Turn-Off and Method of Fabricating this Device". In the structure disclosed in EP—A—0080044, highly-doped $N^+$ or $N^{++}$ diffusions are interspersed within the $P^+$ anode region, which similarly enables the rapid removal of excess electrons in the $N^-$ conductivity type base region 24 upon device turn-off.

Considering now the overall circuit 12 of Fig. 1, the electrical load device 14 is of the type which draws a relatively higher inrush current when initially energized, and a relatively lower operating current thereafter. While various load devices have this particular characteristic, the load device 14 of Fig. 1 is the filament of a discharge type lamp. In accordance with the invention, the hybrid semiconductor switching device 10 included in the circuit 12 includes a parasitic PNPN thyristor structure, as described above, characterized by a holding current rating, and this holding current rating is less than the inrush current of the electrical device 14 and greater than the operating current of the load device 14.

Thus, in operation upon initial turn-on the SCR section 56 of the device 10 is initially activated, to supply the load 14 inrush current. Thereafter, at the relatively low operating current ranges, the IGR section 54 of the device 10 takes over, for high-speed duty cycle controlled switching to provide desired control over the energization of the load device 14. The switching frequency can be up to the maximum operating frequency of an IGR, which is presently in the order of 100 kHz.

While specific embodiments of the invention have been illustrated and described herein, it is realized that numerous modifications and changes will occur to those skilled in the art. For example, the invention applies to complementary devices, wherein P-type regions are used in place of the N-type regions described herein and vice versa.

**Claims**

1. An electrical circuit (12) comprising:

an electrical lamp filament (14) of the type which draws a relatively higher inrush current when initially energized and a relatively lower operating current thereafter; and

an insulated-gate rectifier (10) having a pair of main terminals (42, 44) and a control gate terminal (40), and being of the type including a parasitic PNPN thyristor structure, the main terminals of said insulated-gate rectifier being electrically connected to said electrical lamp filament for controlling energization thereof;

said parasitic PNPN thyristor structure of said insulated-gate rectifier having a holding current rating, and

said insulated-type rectifier being configured and arranged such that said holding current rating is less than the inrush current of said lamp filament and greater than the operating current of said lamp filament,

said insulated-gate rectifier (10) being configured and arranged such that, when the relatively higher inrush current flows through said insulated-gate rectifier (10), the parasitic PNPN thyristor is latched into a conducting state uncontrollable by means of the control gate terminal (40), and such that, when the relatively lower operating current flows through said insulated-gate rectifier, the parasitic PNPN thyristor is not latched into a conducting state, whereby conduction through said insulated-gate rectifier is controllable by means of the control gate terminal (40).

2. An electrical circuit in accordance with claim 1, wherein said insulated gate rectifier includes:

a body (20) of semiconductor material including, in succession therein, anode (22), first base (24), second base (26), and cathode regions (28), said cathode and first base regions (28, 24) being of one conductivity type, and the anode and second base regions being of opposite conductivity type;

a channel portion (34) within said second base region (26) and extending into said second base region (26) from a channel surface (30) contiguous with a surface of said body, said cathode and first base regions (28, 24) being spaced from each other to define the extent of said channel portion therebetween;

an insulated gate electrode (36) over said channel surface configured for inducing in said channel portion, when gate voltage is applied thereto, a conduction channel of the one conductivity type extending between said cathode region and said first base region;

a cathode terminal electrode (46) contacting said cathode region (28);

an anode terminal electrode (48) contacting said anode region (22);

said cathode terminal electrode (46) additionally contacting said second base ergion (26) to provide a cathode short (52) between said cathode and second base regions (28, 26) and a mode crossover current point being determined in part by the contact area of said cathode electrode with said second base region relative to the overall cathode terminal electrode contact area,

said first and second base regions (24, 26), said anode regions (22) and said cathode region (28) being configured and arranged such that, for operating currents below said mode crossover current point, said device functions as an insulated-gate rectifier which conducts in a forward direction when the conduction channel is induced and ceases to support forward conduction when the conduction channel is no longer induced, and such that, for operating currents above said mode crossover current point, said device functions as a thyristor which latches into a forward conduction mode once triggered by a voltage applied to said insulated gate electrode.

3. An electrical circuit in accordance with claim 2, wherein the contact area of said cathode electrode (46) with said second base region (28) relative to the overall cathode terminal electrode contact area is selected such that said mode crossover current point is in the order of one ampere.

**Patentansprüche**

1. Elektrische Schaltungsanordnung (12) enthaltend:

einen elektrischen Lampenglühfaden (14) des Typs, der einen relativ höheren Einschaltstrom zeiht, wenn der Glühfaden eingeschaltet wird, und der anschließend einen relativ kleineren Betriebsstrom zeiht, und

einen Oberflächen-Gleichrichter (10), der zwei Hauptanschlüsse (42, 44) und einen Steuergateanschluß (40) hat und eine parasitäre PNPN-Thyristorstruktur aufweist, wobei die Hauptanschlüsse des Oberflächen-Gleichrichters elektrisch mit dem elektrischen Lampenglühfaden verbunden sind zur Steuerung seiner Speisung,

wobei die parasitäre PNPN-Thyristorstruktur des Oberflächen-Gleichrichters einen Nennhaltestrom aufweist und der Oberflächen-Gleichrichter so konfiguriert und angeordnet ist, daß der Nennhaltestrom kleiner als der Einschaltstrom des Lampenglühfadens und größer als der Betriebsstrom des Lampenglühfadens ist,

wobei der Oberflächen-Gleichrichter (10) so konfiguriert und angeordnet ist, daß, wenn der relativ höhere Einschaltstrom durch den Oberflächen-Gleichrichter (10) fließt, der parasitäre PNPN-Thyristor in einen leitenden Zustand verriegelt ist, der mittels des Steuergateanschlusses (40) nicht steuerbar ist, und daß dann, wenn der relativ kleinere Betriebsstrom durch den Oberflächen-Gleichrichter fließt, der parasitäre PNPN-Thyristor nicht in einen leitenden Zustand verriegelt ist, wodurch die Leitung durch den Oberflächen-Gleichrichter mittels des Steuergateanschlusses (40) steuerbar ist.

2. Elektrische Schaltungsanordnung nach Anspruch 1, wobei der Oberflächen-Gleichrichter aufweist:

einen Körper (20) aus Halbleitermaterial mit, aufeinanderfolgend darin, Anoden- (22), ersten Basis- (24), zweiten Basis- (26) und Kathodenbereichen (28), wobei die Kathoden- und ersten Basisbereiche (28, 24) von dem einen Leitfähigkeitstyp sind und die Anoden- und zweiten Basisbereiche von dem entgegengesetzten Leitfähigkeitstyp sind,

einen Kanalabschnitt (34), der sich in dem zweiten Basisbereich (26) befindet und sich von einer Kanaloberfläche (30) in den zweiten Basisbereich (26) erstreckt benachbart zu einer Oberfläche des Körpers, wobei die Kathoden- und ersten Basisbereiche (28, 24) im Abstand zueinander angeordnet sind, um dazwischen die Ausdehnung des Kanalabschnittes zu begrenzen,

eine isolierte Gate-Elektrode (36) über der Kanaloberfläche, die so aufgebaut ist, daß sie in dem Kanalabschnitt, wenn daran eine Gate-Spannung angelegt ist, einen Leitungskanal des einen Leitfähigkeitstyps hervorruft, der sich zwischen dem Kathodenbereich und dem ersten Basisbereich erstreckt,

eine Kathodenanschlußelektrode (46), die mit dem Kathodenbereich (28) in Kontakt ist,

eine Anodenanschlußelektrode (48), die mit dem Anodenbereich (22) in Kontakt ist,

wobei die Kathodenanschlußelektrode (46) zusätzlich mit dem zweiten Basisbereich (26) in Kontakt ist, um einen Kathodenkurzschluß (52) zwischen den Kathoden- und zweiten Basisbereichen (28, 26) zu bilden, und ein Betriebsartenübergangs-Strompunkt teilweise durch die Kontaktfläche der Kathodenelektrode mit dem zweiten Basisbereich relativ zu der Gesamtkontaktfläche der Kathodenanschlußelektrode bestimmt ist,

wobei die ersten und zweiten Basisbereiche (24, 26), die Anodenbereiche (22) und der Kathodenbereich (28) so konfiguriert und angeordnet sind, daß für Betriebsströme unterhalb des Betriebsartenübergangs-Strompunktes die Vorrichtung als ein Oberflächen-Gleichrichter arbeitet, der in einer Vorwärtsrichtung leitet, wenn der Leitungskanal hervorgerufen ist, und der eine Unterstützung der Vorwärtsleitung beendet, wenn der Leitungskanal nicht länger hervorgerufen ist, so daß, für Betriebsströme oberhalb des Betriebsartenübergangs-Strompunktes, die Vorrichtung als ein Thyristor arbeitet, der in eine Vorwärtsleitungs-Betriebsart verriegelt ist, wenn er einmal durch eine Spannung, die an die isolierte Gate-Elektrode angelegt ist, getriggert ist.

3. Elektrische Schaltungsanordnung nach Anspruch 2, wobei die Kontaktfläche der Kathodenelektrode (46) mit dem zweiten Basisbereich (28) relativ zu der Gesamtkontaktfläche der Kathodenanschlußelektrode so gewählt ist, daß der Betriebsartenübergangs-Strompunkt in der Größenordnung von einem Ampere ist.

**Revendications**

1. Un circuit électrique (12) comprenant:

un filament de lampe électrique (14) du type absorbant un courant de pointe relativement supérieur au moment de la mise sous tension et un courant de functionnement relativement inférieur par le suite; et un redresseur à grille isolée (10) comportant une paire de bornes principales (42, 44) et une borne de grille de commande (40), et étant du type qui comprend une structure de thyristor PNPN parasite, les bornes principales de ce redresseur à grille isolée étant connectées électriquement au filament de lampe électrique pour alimenter ce dernier de façon commandée;

la structure de thyristor PNPN parasite du redresseur à grille isolée ayant un courant de maintien, et le redresseur à grille isolée étant conçu de façon que son courant de maintien soit inférieur au courant de pointe du filament de lampe et soit supérieur au courant de fonctionnement du filament de lampe,

le redresseur à grille isolée (10) étant conçu de façon que, lorsque le courant de pointe relativement supérieure circule dans le redresseur à grille isolée (10), le thyristor PNPN parasite soit verrouillé dans un état de conduction qui ne peut pas être commandé au moyen de la borne de grille de commande (40), et de façon que lorsque le courant de fonctionnement relativement inférieur circule dans le redresseur à grille isolée, le thyristor PNPN parasite ne soit pas verrouillé dans un état de conduction, grâce à quoi la conduction dans le redresseur à grille isolée peut être commandée au moyen de la borne de grille de commande (40).

2. Un circuit électrique selon la revendication 1, dans lequel le redresseur à grille isolée comprend:

un bloc (20) de matériau semiconducteur comprenant, en succession, une région d'anode (22), une première région de base (24), une seconde région de base (26) et une région de cathode (28), la région de cathode et la première région de base (28, 24) étant d'un type de conductivité, et la région d'anode et la seconde région de base étant du type de conductivité opposé;

une partie de canal (34) formée à l'intérieur de la seconde région de base (26) et s'étendant dans la seconde région de base (26) à partir d'une surface de canal (30) contigué à une surface du bloc, la région de cathode et la première région de base (28, 24) étant mutuellement espacées pour définir entre elles l'étendue de la partie de canal;

une électrode de grille isolée (36) sur la surface de canal, conçue pour induire dans la partie de canal, lorsqu'une tension de grille lui est appliquée, un canal de conduction du type de conductivité mentionné en premier, s'étendant entre la région de cathode et la première région de base;

une électrode de borne de cathode (46) venant en contact avec la région de cathode (28);

une électrode de borne d'anode (48) venant en contact avec la région d'anode (22);

l'électrode de borne de cathode (46) venant en outre en contact avec la seconde région de base (26) pour établir un court-circuit de cathode (52) entre la région de cathode et la seconde région de base (28, 26), et un point de courant de transition de mode étant déterminé en partie par l'aire de contact de l'électrode de cathode avec la seconde région de base, rapportée à l'aire de contact totale de l'électrode de borne de cathode,

les première et seconde régions de base (24, 26), la région d'anode (22) et la région de cathode (28) étant conçues de façon que, pour des courants de fonctionnement inférieurs au point de courant de transition de mode, le dispositif fonctionne à la manière d'un redresseur à grille isolée qui conduit en sens direct lorsque le canal de conduction est induit et qui cesse de permettre la conduction en sens direct lorsque le canal de conduction n'est plus induit, et de façon que, pour des courants de fonctionnement supérieurs au point de courant de transition de mode, ce dispositif fonctionne à la manière d'un thyristor qui se verrouille dans un mode de conduction en sens direct une fois qu'il est amorcé par une tension appliquée à l'électrode de grille isolée.

3. Un circuit électrique selon la revendication 2, dans lequel l'aire de contact de l'électrode de cathode (46) avec la seconde région de base (28), rapportée à l'aire de contact totale de l'électrode de borne de cathode, est sélectionnée de façon que le point de courant de transition de mode soit de l'ordre d'un ampère.

*FIG. 1*